(19) **Europäisches Patentamt**
**European Patent Office**
**Office européen des brevets**

(11) **EP 0 918 042 A1**

(12) **EUROPÄISCHE PATENTANMELDUNG**

(43) Veröffentlichungstag:
**26.05.1999 Patentblatt 1999/21**

(51) Int. Cl.$^6$: **C03C 17/245**, C23C 14/08,
C23C 14/34

(21) Anmeldenummer: **97120354.2**

(22) Anmeldetag: **20.11.1997**

(84) Benannte Vertragsstaaten:
**AT BE CH DE DK ES FI FR GB GR IE IT LI LU MC NL PT SE**
Benannte Erstreckungsstaaten:
**AL LT LV MK RO SI**

(71) Anmelder: **Balzers Hochvakuum AG**
**9477 Trübbach (CH)**

(72) Erfinder:
• **Stollenwerk, Johannes, Dr.**
**63571 Gelnhausen (DE)**

• **Daube, Christoph, Dr.**
**63755 Alzenau (DE)**
• **Guerke, Achim**
**63739 Aschaffenburg (DE)**

(74) Vertreter:
**Troesch Scheidegger Werner AG**
**Patentanwälte,**
**Siewerdtstrasse 95,**
**Postfach**
**8050 Zürich (CH)**

(54) **Mit mindestens einer MgO-Schicht beschichtetes Substrat**

(57) Es wird ein Substrat mit einer Ausdehnung von mindestens 100 mm x 100 mm vorgeschlagen, welches mit einer MgO-Schicht beschichtet ist, wobei, unter- sucht mit der Θ-2Θ-Methode, die Schicht eine überra- gende Spitze bei (111) aufweist.

FIG.4

## Beschreibung

Die vorliegende Erfindung betrifft ein mit mindestens einer MgO-Schicht beschichtetes Substrat mit einer Ausdehnung von mindestens 100mm x 100mm nach dem Oberbegriff von Anspruch 1, weiter ein Verfahren zur Herstellung eines beschichteten Substrates, bevorzugterweise des vorerwähnten, nach Anspruch 9 sowie eine Beschichtungsanordnung hierfür nach Anspruch 14.

Es ist bekannt, relativ grossflächige Substrate, wie insbesondere Plasma-Display-Panel-Substrate, durch Elektronenstrahlbedampfen mit einer MgO-Schicht hoher Qualität zu beschichten. Die hohe Qualität ergibt sich beispielsweise durch die, verglichen mit der Dichte $\rho$ von MgO-Bulkmaterial von 3,58g/cm3, geforderte sehr hohe Dichte des MgO-Schichtmaterials, nämlich zwischen 85% und 95% der erwähnten Bulkmaterialdichte $\rho$.

Im nachfolgenden wird der Begriff "$\Theta$-2$\Theta$-Methode" verwendet.

-   Diese Methode ist in F. Kohlrausch, Praktische Physik, Band 2, 23. Auflage, Seite 753, B.G. Teubner, Stuttgart 1985, definiert. Demnach besteht das Bragg-Verfahren in der Drehung des Kristalls um $\Theta$, gekoppelt mit der Drehung des Detektors um 2$\Theta$, und wird hier als "$\Theta$-2$\Theta$-Methode" bezeichnet.

-   Wenn von "Spitzen bei (xyz)" gesprochen wird, so ist damit der peak-Verlauf des $\Theta$-2$\Theta$-Methoden-Resultat-Verlaufes bzw. Diagrammes verstanden, der der (xyz)-Orientierung entspricht, wie üblicherveise in der Kristallografie verwendet.

-   Wenn von einer "überragenden Spitze" gesprochen wird, so heisst dies im $\Theta$-2$\Theta$-Methoden-Diagramm eine Spitze, die höher ist als alle anderen.

-   Wenn vom Vorhandensein einer einzigen Spitze die Rede ist, ist damit eingeschlossen das Vorhandensein von Spitzen höherer Ordnung, also z.B. einer Spitze bei (222), wenn vom Vorhandensein allein der Spitze bei (111) gesprochen wird.

Das durch Elektronenstrahlbedampfen abgelegte Schichtmaterial weist den wesentlichen Nachteil auf, dass es bei Untersuchung mit der $\Theta$-2$\Theta$Methode keine überragende Spitze aufweist.

Die vorliegende Erfindung schlägt nun ein Substrat eingangs genannter Art vor, an welchem die Schicht gemäss Kennzeichen von Anspruch 1 eine überragende Spitze aufweist. Insbesondere bei beschichteten Plasma-Display-Panel-Substraten ist oft eine überragende Spitze bei (111) erwünscht oder gar ausschliesslich eine Spitze bei (111). Die Herstellung von derartigen Substraten mittels Elektronenstrahlverdampfens ist nicht möglich.

Es kann auch allein - also an Stelle der überragenden Spitze bei (111) - oder zusätzlich eine Spitze bei (200) und/oder bei (220) vorhanden sein oder an anderen Stellen.

Dem Wortlaut von Anspruch 3 folgend, weist die Schicht am erfindungsgemässen Substrat, weiter bevorzugterweise, einen Brechungsindex n für Licht in einem Wellenlängenbereich von mindestens 400nm bis 800nm, vorzugsweise gar von 350nm bis 820nm, auf, für den gilt:

$$1{,}6 \leq n \leq 1{,}8,$$

vorzugsweise

$$1{,}65 \leq n \leq 1{,}75,$$

vorzugsweise

$$1{,}65 \leq n \leq 1{,}7.$$

Gemäss Wortlaut von Anspruch 4 ist weiter die Oberflächenrauheit der Schicht über das Substrat homogen und liegt vorzugs-weise zwischen 0,2nm RMS und 0,5nm RMS, gemessen mittels Raster-Kraftmikroskopie.

Obwohl das erfindungsgemässe Substrat insbesondere dank der realisierten, mittels der $\Theta$-2$\Theta$Methode gemessenen, überragenden Spitze Eigenschaften aufweist, die ein Substrat, herkömmlicherweise hergestellt, nicht aufweist, werden erfindungsgemäss und nach Anspruch 5 Schichtmaterialdichten realisiert, die mindestens 85%, vorzugsweise mindestens 90%, der Dichte von stöchiometrischem MgO-Bulkmaterial betragen. An MgO-Bulkmaterial ist die Dichte $\rho = 3{,}58$g/cm3.

Im weiteren ist bevorzugterveise, und wie in Anspruch 6 angegeben, am erfindungsgemässen Substrat das MgO-Material stöchiometrisch vorliegend.

Das erfindungsgemässe Verfahren zur Herstellung insbesondere des erwähnten erfindungsgemässen Substrates zeichnet sich nach dem Kennzeichen von Anspruch 9 aus. Dadurch ist es einerseits möglich, das erwähnte erfindungsgemässe Substrat überhaupt zu realisieren, und dies, dank der bei dem erfindungsgemässen, reaktiven Sputterbeschichten erreichten hohen Beschichtungsraten und der hohen Targetmaterialausnützung, äusserst kostengünstig. Damit können die erwähnten grossflächigen Substrate kostengünstig bei hohen Durchsätzen industriell hergestellt werden.

Eine hierzu eingesetzte bevorzugte Beschichtungsanlage zeichnet sich nach dem Wortlaut von Anspruch 14 aus.

Die Erfindung wird anschliessend beispielsweise anhand von Figuren erläutert.

Es zeigen:

Fig. 1      perspektivisch und schematisch, eine erfindungsgemässe Anlage zur Durchführung des erfindungsgemässen Verfahrens und zur Realisation des erfindungsgemässen Substrates;

Fig. 2 an einem erfindungsgemässen Substrat, nach dem erfindungsgemässen Verfahren und, bevorzugterweise, mit der erfindungsgemässen Anlage beschichtet, das $\Theta$-2$\Theta$-Methoden-Diagramm mit überragenden Spitzen bei (111) bzw. bei (200) und bei variiertem Sauerstofffluss;

Fig. 3 in Darstellung analog zu Fig. 2, die Einstellung der Spitzen durch Variation der Substrattemperatur T beim erfindungsgemässen Beschichten;

Fig. 4 in Darstellung analog zu Fig. 2, die Spitzen an einem erfindungsgemässen Substrat (b) und an polykristallinem MgO-Pulver (a) als Vergleich;

Fig. 5 an einem erfindungsgemässen Substrat, hergestellt nach dem erfindungsgemässen Verfahren und, bevorzugterweise, mit der erfindungsgemässen Anlage, den Verlauf des Absorptionskoeffizienten in Funktion der Wellenlänge einfallenden Lichtes;

Fig. 6 an einem erfindungsgemässen Substrat gemäss Fig. 5, den Verlauf des Brechungsindex n in Funktion der Wellenlänge einfallenden Lichtes;

Fig. 7 den spektralen Verlauf der prozentualen Transmission von AF 45 Glas (a), als Vergleich, und an einem erfindungsgemässen Substrat mit dem AF 45 Glas;

Fig. 8 entlang der Ebene E von Fig. 1 betrachtet, die Verteilung auf das Substrat in stationären Zustand abgelegten Schichtmaterials in Prozent des Maximumwertes;

Fig. 9 an einem erfindungsgemässen Plasma-Display-Panel-Substrat die Verteilung der MgO-Schichtdicke;

Fig. 10 an einem bei T = 200°C beschichteten erfindungsgemässen Substrat die mittels Raster-Kraftmikroskopie aufgenommene Oberflächenrauheit.

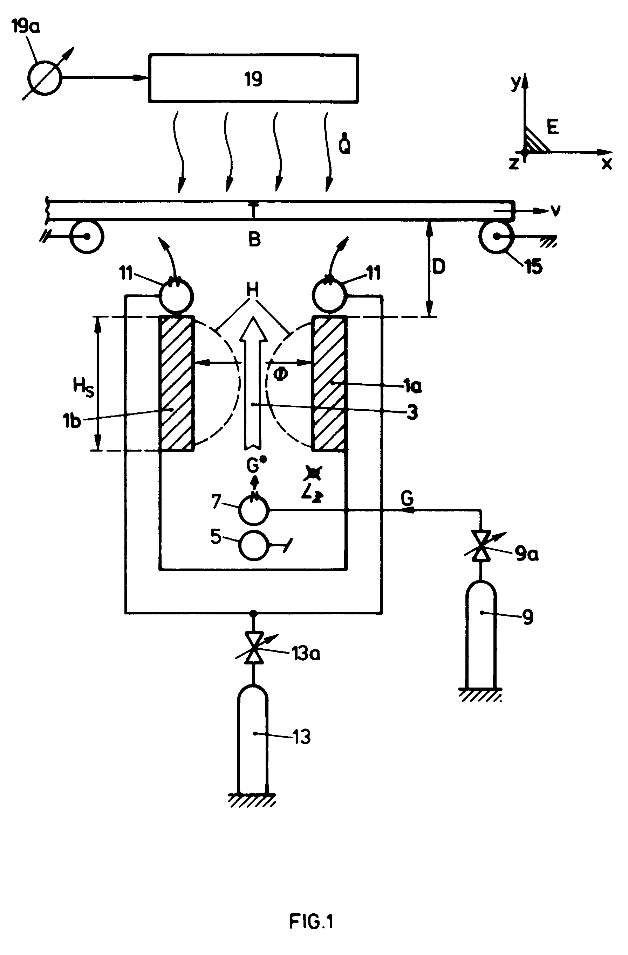

In Fig. 1 ist schematisch eine Beschichtungsanlage dargestellt, welche sich zur Durchführung des erfindungsgemässen Verfahrens und zur Herstellung des erfindungsgemässen Substrates eignet. Bezüglich weiterer Anlagen, welche sich mindestens ebenso gut hierfür eignen, sei vollumfänglich auf die EP-0 803 587 verwiesen bzw. auf die US-Anmeldung Nr. ..................................... Solche Anlagen werden "Gasfluss-Sputterquellen"-Anlagen genannt.

Wesentlich an der eingesetzten Gasfluss-Sputterquelle ist mindestens ein Targetpaar mit Targets 1a und 1b, welche zwischen sich gemäss Fig. 1 einen beidseits offenen, in Z-Richtung ausgedehnten Spalt 3 bzw., gemäss der EP-0 803 587, einen in sich geschlossenen, in Z-Richtung ausgedehnten Spalt definieren. Die Spaltausdehnung in Z-Richtung ist z.B. 1600mm. Die Targets werden bevorzugterweise (nicht dargestellt) DC-betrieben, wobei auch ein AC- bzw. ein DC-Betrieb mit überlagertem AC- bzw. ein gepulster DC-Betrieb möglich ist. Im einen Endbereich des Spaltes 3 ist eine Anodenanordnung 5 vorgesehen sowie eine sich entlang des Spaltes 3 erstreckende Gasausdüsanordnung 7, die, wie schematisch dargestellt, mit einem Arbeitsgastank 9, vorzugsweise mit Argon, über ein Stellorgan 9a verbunden ist.

An dem der Gaseindüsanordnung 7 abgewandten Spaltbereich ist eine weitere Gaseindüsanordnung 11 vorgesehen, welche, wie wiederum schematisch dargestellt, über ein Stellorgan 13a mit einem Sauerstoff enthaltenden Gastank 13 verbunden ist. Oberhalb des mit der Sauerstoff-Eindüsanordnung 11 versehenen Spaltendes ist, wie schematisch bei 15 dargestellt, eine Träger- und Vorschubanordnung für ein planes Substrat 17 mit einer Ausdehnung von mindestens 100mm x 100mm vorgesehen, womit das Substrat 17, senkrecht zu der in Fig. 1 eingetragenen Gasflussrichtung G des Arbeitsgases durch den Spalt 3, vom Spaltende mit der Sauerstoff-Eindüsanordnung 11 beabstandet, vorzugsweise linear gleichförmig durchbewegt wird.

Auch bei der in Fig. 1 dargestellten Anordnung mit einem seitlich beidseits offenen Spalt 3 werden bevorzugterweise die in der obgenannten EP-0 803 587 definierten Betriebsparameter und geometrischen Verhältnisse realisiert:

- Totaldruck im Beschichtungsraum B: 0,1 bis 10mbar;

- Partialdruck $O_2$: bis 10% vom Totaldruck im Beschichtungsraum B;

- Austrittsströmung des Arbeitsgases G -Ar- aus der Spaltöffnung in den Behandlungsraum B:
  Die Arbeitsgas-, vorzugsweise Ar-Gasströmung G wird im knudsenschen oder viskosen Bereich realisiert. Dabei gilt:
  Knudsenscher Bereich:

  $$10^{-2}\text{mbar} \cdot \text{cm} \leq p \cdot \Phi \leq 0,6\text{mbar} \cdot \text{cm};$$

  Viskoser Bereich:

0,6mbar · cm < p · Φ,

mit p als Totaldruck im Spalt 3 und Φ als Spaltbreite.

Vorzugsweise wird die Gasströmung im knudsenschen Bereich gewählt. Weiter gilt vorzugsweise:

$$10sccm/cm^2 \leq F \leq 200sccm/cm^2,$$

mit F als Arbeitsgasfluss pro Spaltöffnungs-Flächeneinheit,
vorzugsweise

$$20sccm/cm^2 \leq F \leq 50sccm/cm^2.$$

Spaltbreite Φ bzw. Abstand der Targets 1a, 1b:

$$5mm \leq \Phi \leq 40mm,$$

vorzugsweise

$$\Phi \leq 25mm,$$

vorzugsweise

$$8mm \leq \Phi \leq 20mm.$$

Spalttiefe (Targetbreite) $H_s$ in Richtung G von Fig. 1:

$$1cm \leq H_s \leq 20cm,$$

Spalthöhe $L_z$: z.B. 1600mm.
Falls, magnetronähnlich, an den beiden Targets 1a, 1b ein tunnelförmiges Magnetfeld H realisiert wird, so bevorzugterweise so, dass, parallel zu den Zerstäubungsflächen der beiden Targets 1a und 1b, in der Mitte des Spaltes 3 gemessen, gilt:

$$150 \, Gauss \leq H \leq 1200 \, Gauss,$$

dabei vorzugsweise $H \geq 300 \, Gauss$,
bevorzugterweise $300 \, Gauss \leq H \leq 800 \, Gauss$.
Mittels einer an einer Stellanordnung 19a steuer- oder regelbaren Heiz- und/oder Kühlanordnung wird die Substrattemperatur T im Bereich B eingestellt.
Eine wie in Fig. 1 schematisch dargestellte Beschichtungsanlage wurde, unter Einhalt der vorerwähnten Dimensionierungs- und Betriebsregeln, wie folgt aufgebaut und betrieben:

-    Targetmaterial 1a, 1b: Mg3N5, Reinheit 99,95%;

-    Targetentladespannung bezüglich der auf Masse geschalteten Anode 5: 310V;

-    Entladestrom: 27A;

-    Leistungsdichte pro Targetflächeneinheit bei planen Zerstäubungsneuflächen: $15W/cm^2$;

-    Arbeitsgas: Ar;
         Fluss: 8000sccm;

-    Reaktivgas: $O_2$, Fluss variabel;

-    Totaldruck im Bereich B: 0,4mbar;

-    Substrattemperatur: 200°C, variabel;

-    Substratfläche: 300 x 400mm$^2$;

-    dynamische Beschichtungsrate: 30-50nm.m/min;

-    Substrat-Spaltabstand D: 50mm;

-    Vorschub v: 0,7m/min

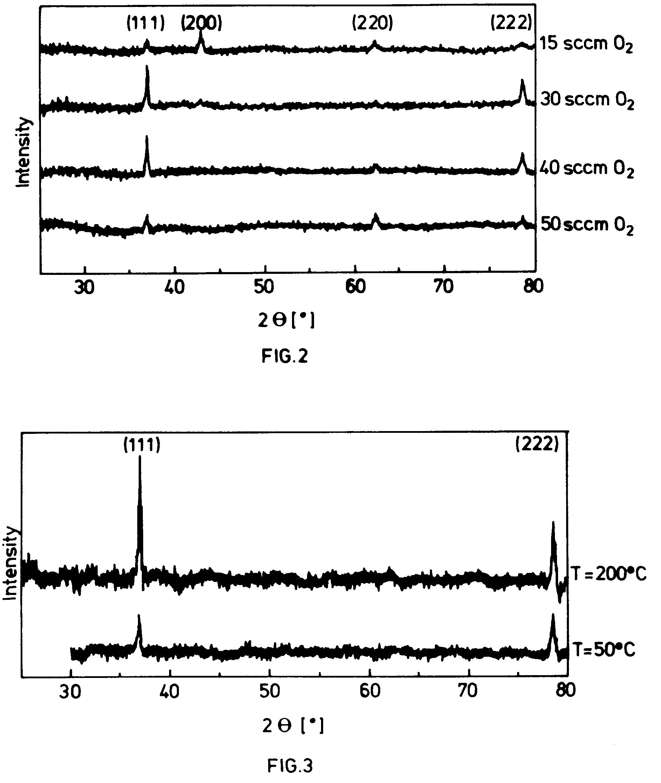

In Fig. 2 ist der Messungsverlauf der Θ-2Θ-Methode an der MgO-Schicht am erfindungsgemäss beschichteten Plasma-Display-Panel-Glassubstrat -AF 45- dargestellt. An der Anordnung gemäss Fig. 1 wurde der Sauerstofffluss, wie bei 13a dargestellt, verändert. Wie ersichtlich, können mit Einstellung dieses Flusses Lage und Höhe der auftretenden Spitzen eingestellt werden. Auf einem Plasma-Display-Panel-Substrat war vorliegendenfalls ausschliesslich eine Spitze bei (111) erwünscht, was mit einem Sauerstofffluss von 30sccm bzw. 40sccm erreicht wurde. Bei (222) erscheint das Signal zweiter Ordnung.
Es ist ersichtlich, dass durch Einstellung des Sauerstoff-Gasflusses beim erfindungsgemässen Herstellverfahren die Lage und Ausprägung der auftretenden Spitzen gewählt werden kann, wobei auch andere Lagen, wie z.B. bei (200) und/oder (220), eingestellt werden können.
In Fig. 3 ist dargestellt, dass am erfindungsgemässen Herstellverfahren, gemäss Fig. 1, bzw. generell mittels der Gasfluss-Sputterquelle, auch mit der Substrattemperatur T während des Beschichtungsvorganges die Spitzen eingestellt werden können. Bevorzugterweise werden beide Parameter, nämlich Sauerstofffluss gemäss Fig. 2 und Substrattemperatur T, zur Einstellung der Lage und Ausprägung der Spitzen eingesetzt.

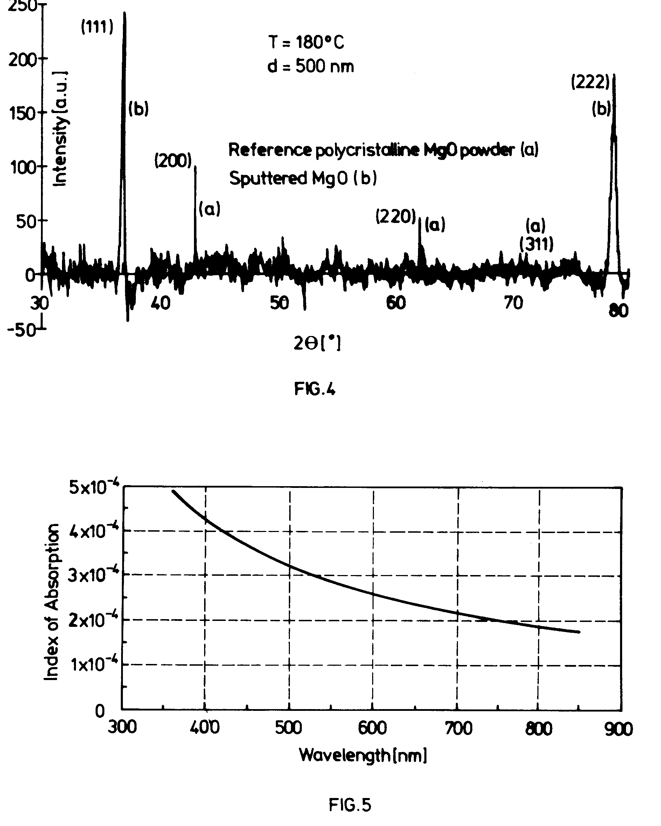

In Fig. 4 ist der Messverlauf (b) der Θ-2Θ-Methode dargestellt, aufgenommen an einem erfindungsgemässen Substrat mit einer 500nm dicken MgO-Schicht, abgelegt bei einer Temperatur T = 180°C. Die Spitzen (a) bei (200), (220) und (311) sind Spitzen an polykristallinem MgO-Pulver, als Vergleich.

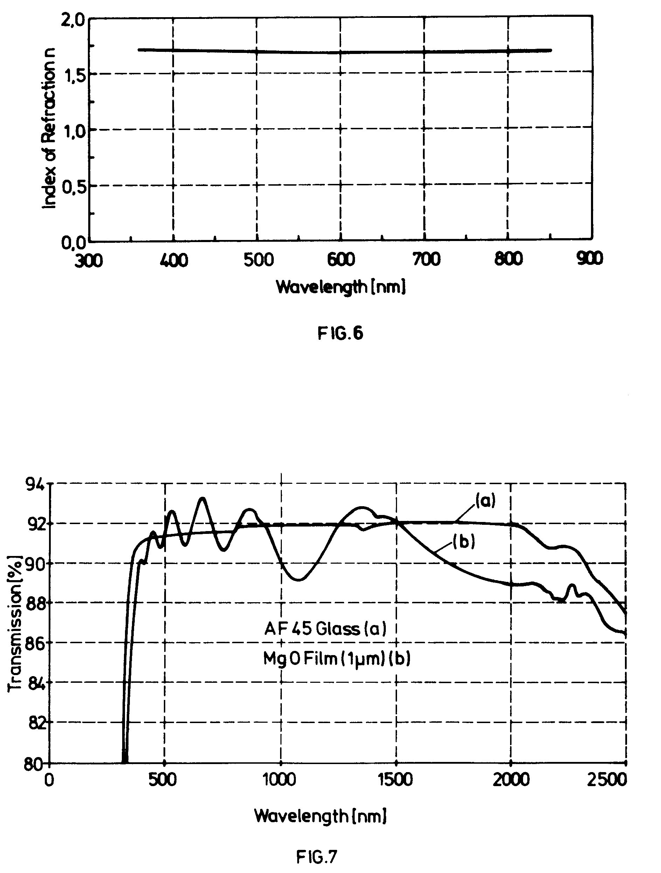

In Fig. 5 ist der Verlauf des Absorptionskoeffizienten in Funktion der Wellenlänge einfallenden Lichtes an dem wie erwähnt hergestellten erfindungsgemässen Substrat bzw. der darauf aufgebrachten MgO-Schicht dargestellt.

Bei dem wie erwähnt wesentlich unwirtschaftlicheren Elektronenstrahlbedampfen von Substraten mit hochqualitativen MgO-Schichten werden Brechungsindizes nahe beim erwünschten Wert von 1,7 erzielt. Wie sich aus Fig. 6 an einem erfindungsgemässen Substrat ergibt, ergeben sich auch hier Brechungsindexwerte zwischen 1,6 und 1,8, vorzugsweise zwischen 1,65 und 1,75, besonders bevorzugt, und wie in Fig. 6 dargestellt, zwischen 1,65 und 1,7. Dies bevorzugt über einen Wellenlängenbereich von mindestens 400nm bis 800nm, gemäss Fig. 6 gar zwischen 350nm und 820nm.

In Fig. 7 ist die prozentuale Transmission von unbeschichtetem AF 45 Glas (a) und (b) an einem erfindungsgemässen Substrat mit dem AF 45 Glas und beschichtet mit einer 1μm dicken MgO-Schicht dargestellt.

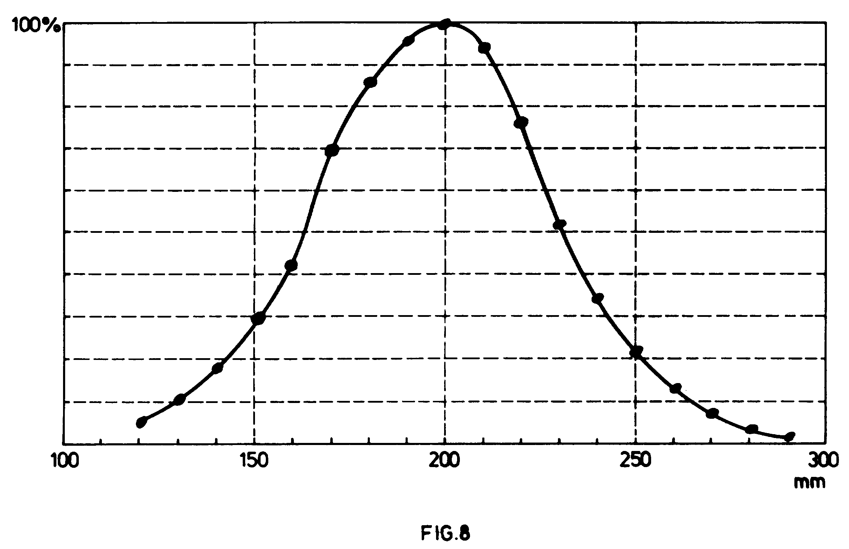

In Fig. 8 ist, rückschauend auf die Beschichtungsanordnung gemäss Fig. 1, die Beschichtungsratenverteilung in der in Fig. 1 eingetragenen Ebene E dargestellt, bei stationär gehaltenem Substrat. Wie erwähnt, beträgt der Substrat-zu-Spalt-Abstand D 50mm.

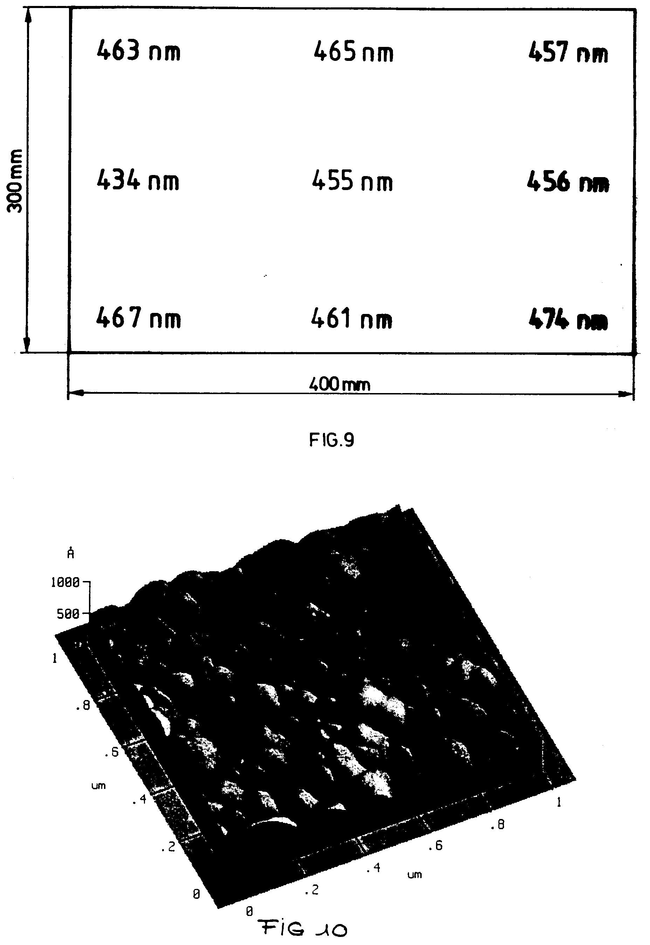

In Fig. 9 ist an einem erfindungsgemässen Plasma-Display-Panel-Substrat mit der Ausdehnung 300mm x 400mm die Schichtdickenverteilung angegeben. Daraus ist ersichtlich, dass die Schichtdickenverteilung trotz der Grösse des Substrates wesentlich besser ist als ± 10% bezüglich des Schichtdicken-Mittelwertes.

In Fig. 10 ist schliesslich die mittels Raster-Kraftmikroskopie aufgenommene Oberflächenrauheit an einer bei 200°C an einem erfindungsgemässen Substrat abgelegten MgO-Schicht mit der Dicke 500nm.

An dem erfindungsgemässen Substrat, insbesondere realisiert nach dem erfindungsgemässen Verfahren, kann die Oberflächenrauheit insbesondere durch Wahl der Beschichtungstemperatur in einem grossen Bereich gewählt werden, nämlich zwischen 0,2nm RMS und 0,5nm RMS, gemessen mittels Raster-Kraftmikroskopie.

Mit dem erfindungsgemässen Substrat, insbesondere dem erfindungsgemässen Plasma-Display-Panel-Substrat, wird, industriell kostengünstig fertigbar, gezielt eine überragende Spitze insbesondere bei (111) vorgeschlagen, an einer MgO-Schicht mit hoher Dichte. Beim erfindungsgemässen Herstellungsverfahren sind sehr hohe dynamische Beschichtungsraten von weit über 30nm.m/min erzielbar, was mit zur erwähnten Produktivität beiträgt, nebst der Tatsache, dass das Targetmaterial zu über 70% ausnützbar ist.

Es ist darauf hinzuweisen, dass beim Elektronenstrahlverdampfen das Verdampfungsmaterial in der Grössenordnung von 10% ausgenützt werden kann. Obwohl im heutigen Zeitpunkt noch nicht erprobt, ist zu vermuten, dass durch Einsatz von Gasfluss-Sputterquellen gemäss der EP-0 803 587 noch weit höhere Beschichtungsraten erzielbar sind, insbesondere unter Einsatz magnetronähnlicher Magnetfelder.

Im weiteren wurde mittels Electron Probe Micro Analysis (EPMA) festgestellt, dass die abgelegten MgO-Schichten keine Arbeitsgas-, insbesondere Ar-Einschlüsse aufweisen. Auf Grund der Einstellbarkeit der Oberflächenrauheit und der realisierten überragenden Spitzen ist es möglich, für ein erfindungsgemässes Plasma-Display-Panel-Substrat die Oberfläche pro beschichtete Substratflächeneinheit zu optimieren, was zum Erzielen hoher Sekundärelektronen-Emissionskoeffizienten wünschbar ist. Dabei scheint eine überragende Spitze bei (111) optimal zu sein. Dabei ergibt sich, wie der Quervergleich von Fig. 3 (T = 200°C) und 10 zeigt, bei der Spitze bei (111) auch eine hohe Oberflächenrauheit im Bereich von 0,5nm RMS.

## Patentansprüche

1. Mit mindestens einer MgO-Schicht beschichtetes Substrat mit einer Ausdehnung von mindestens 100mm x 100mm, dadurch gekennzeichnet, dass die Schicht mindestens eine überragende Spitze im Messverlauf der Θ-2Θ-Methode aufweist.

2. Substrat nach Anspruch 1, dadurch gekennzeichnet, dass die Schicht eine Spitze bei (200) und/oder bei (220) und/oder bei (111) aufweist, dass vorzugsweise eine Spitze bei (111) vorhanden und die überragende ist und weiter vorzugsweise als einzige vorhanden ist.

3. Substrat, vorzugsweise nach einem der Ansprüche 1 bis 2, dadurch gekennzeichnet, dass die Schicht einen Brechungsindex n für Licht in einem Wellenlängenbereich von mindestens 400nm bis 800nm, vorzugsweise von mindestens 350nm bis 820nm aufweist, für den gilt:

$$1,6 \le n \le 1,8,$$

vorzugsweise

$$1,65 \le n \le 1,75,$$

vorzugsweise

$$1,65 \le n \le 1,7.$$

4. Substrat, vorzugsweise nach einem der Ansprüche 1 bis 3, dadurch gekennzeichnet, dass die Oberflächenrauheit der Schicht homogen verteilt zwischen 0,2nm RMS und 0,5nm RMS liegt, gemessen mittels Raster-Kraftmikroskopie.

5. Substrat, vorzugsweise nach einem der Ansprüche 1 bis 4, dadurch gekennzeichnet, dass die Dichte des Schichtmaterials mindestens 85%, vorzugs-

weise mindestens 90% von stöchiometrischem MgO Bulkmaterial ist, die $\rho$ = 3,58g/cm3 beträgt.

6. Substrat, vorzugsweise nach einem der Ansprüche 1 bis 5, dadurch gekennzeichnet, dass das Schichtmaterial stöchiometrisches MgO umfasst, vorzugsweise das MgO stöchiometrisch ist.

7. Substrat nach einem der Ansprüche 1 bis 6, dadurch gekennzeichnet, dass das Substrat ein Plasma-Display-Panel-Substrat ist, wie z.B. ein Glassubstrat.

8. Substrat nach einem der Ansprüche 1 bis 7, dadurch gekennzeichnet, dass die Schicht durch reaktives Sputtern, vorzugsweise gemäss mindestens einem der nachfolgenden Verfahrensansprüche hergestellt ist, insbesondere mittels einer Gasfluss-Sputterquelle.

9. Verfahren zur Herstellung eines Substrates, vorzugsweise eines Substrates nach einem der Ansprüche 1 bis 8, dadurch gekennzeichnet, dass man

   - ein Arbeitsgas (G) durch mindestens einen zwischen zwei Sputtertargets aus Mg gebildeten Spalt gegen ein vom Spaltende beabstandetes Substrat (17) strömen lässt und dabei die Reinheit der Mg-Targets zu mindestens 99% wählt,

   - im Bereich (B) zwischen Spaltende und Substrat Sauerstoff einbringt,

   - die Substrattemperatur während des Beschichtungsvorganges vorgibt (19).

10. Verfahren nach Anspruch 9, dadurch gekennzeichnet, dass man die Lage und/oder Ausprägung von Spitzen am $\Theta$-$2\Theta$-Methoden-Diagramm durch Einstellung (13a) der pro Zeiteinheit eingebrachten Sauerstoffmenge und/oder der Substrattemperatur (19) steuert.

11. Verfahren nach einem der Ansprüche 9 oder 10, dadurch gekennzeichnet, dass man eine statische Beschichtungsrate $r_s$ von mindestens 5nm/sec einstellt.

12. Verfahren nach einem der Ansprüche 9 bis 11, dadurch gekennzeichnet, dass man das Substrat über den Spalt durchbewegt, vorzugsweise gleichförmig linear.

13. Verfahren nach Anspruch 12, dadurch gekennzeichnet, dass man eine dynamische Beschichtungsrate von mindestens 30nm.m/min, vorzugsweise von mindestens 35nm.m/min, einstellt.

14. Beschichtungsanordnung zur Ausführung des Verfahrens nach einem der Ansprüche 9 bis 13, dadurch gekennzeichnet, dass sie umfasst:

   - zwei zwischen sich einen Spalt (3) aufspannende Mg-Targets (1a, 1b) mit einer Mg-Reinheit von mindestens 99%,

   - im einen Endbereich des Spaltes eine Anodenanordnung (5) sowie eine mit einem Arbeitsgastank (9) verbundene Gasausdüsanordnung (7),

   - eine Substratträger- und Vorschubeinrichtung (15), mittels welcher ein planes Substrat (17), beabstandet von dem dem einen Spaltendbereich gegenüberliegenden andern Spaltendbereich (B), über den Spalt (3) bewegbar ist,

   - einer in den Zwischenraum (B) zwischen anderem Spaltendbereich und auf der Substratträger- und Vorschubanordnung (15) angeordneten Substrat (17) wirkende, mit einem Sauerstofftank (13) verbundene Gasausdüsanordnung.

15. Anordnung nach Anspruch 14, dadurch gekennzeichnet, dass eine vorzugsweise einstellbare Heiz- und/oder Kühleinrichtung (19) für das Substrat (17) vorgesehen ist.

FIG.1

FIG.2

FIG.3

FIG.4

FIG.5

9

FIG.6

FIG.7

FIG.8

EP 0 918 042 A1

463 nm        465 nm        457 nm

434 nm        455 nm        456 nm

467 nm        461 nm        474 nm

300 mm

400 mm

FIG.9

Å

1000
500

1

.8

.6
um
.4

.2

0

0        .2        .4        .6        .8        1
                        um

FIG 10

**Europäisches Patentamt**

# EUROPÄISCHER RECHERCHENBERICHT

Nummer der Anmeldung

EP 97 12 0354

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int.Cl.6) |
|---|---|---|---|
| D,X | EP 0 803 587 A (BALZERS HOCHVAKUUM AG) 29.Oktober 1997 * Spalte 2, Zeile 24 - Spalte 4, Zeile 35 * * Spalte 8, Zeile 19 - Spalte 11, Zeile 23 * --- | 1-15 | C03C17/245 C23C14/08 C23C14/34 |
| X | PATENT ABSTRACTS OF JAPAN vol. 013, no. 562 (C-665), 13.Dezember 1989 & JP 01 234398 A (MATSUSHITA ELECTRIC IND CO LTD), 19.September 1989, * Zusammenfassung * --- | 1-6,8 | |
| X | YASUHISA KANEKO ET AL: "PREPARATION OF MGO THIN FILMS BY RF MAGNETRON SPUTTERING" JAPANESE JOURNAL OF APPLIED PHYSICS, Bd. 30, Nr. 5, 1.Mai 1991, Seiten 1091-1092, XP000263714 * das ganze Dokument * --- | 1-6,8 | |
| X | BRULEY J ET AL: "NANOSTRUCTURE AND CHEMISTRY OF A (100)MGO/(100)GAAS INTERFACE" APPLIED PHYSICS LETTERS, Bd. 65, Nr. 5, 1.August 1994, Seiten 564-566, XP000464872 * das ganze Dokument * --- | 1-6,8 | **RECHERCHIERTE SACHGEBIETE (Int.Cl.6)** C03C C23C |
| X | TSUGUO ISHIHARA ET AL: "STRUCTURE OF MGO FILMS PREPARED BY ION BEAM SPUTTERING" JOURNAL OF THE CERAMIC SOCIETY OF JAPAN, INTERNATIONAL EDITION, Bd. 97, Nr. 8, 1.August 1989, Seiten 4-10, XP000083701 * das ganze Dokument * --- -/-- | 1-6,8 | |

Der vorliegende Recherchenbericht wurde für alle Patentansprüche erstellt

| Recherchenort | Abschlußdatum der Recherche | Prüfer |
|---|---|---|
| DEN HAAG | 20.April 1998 | Van Bommel, L |

KATEGORIE DER GENANNTEN DOKUMENTE

X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder nach dem Anmeldedatum veröffentlicht worden ist
D : in der Anmeldung angeführtes Dokument
L : aus anderen Gründen angeführtes Dokument
...............
& : Mitglied der gleichen Patentfamilie, übereinstimmendes Dokument

# EP 0 918 042 A1

Europäisches  
Patentamt

**EUROPÄISCHER RECHERCHENBERICHT**

Nummer der Anmeldung

EP 97 12 0354

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int.Cl.6) |
|---|---|---|---|
| A | EP 0 570 182 A (TOPPAN PRINTING CO LTD ;LEYBOLD AG (DE)) 18.November 1993 * Seite 2, Zeile 3 - Seite 3, Zeile 32 * ----- | 1-15 | |

RECHERCHIERTE SACHGEBIETE (Int.Cl.6)

Der vorliegende Recherchenbericht wurde für alle Patentansprüche erstellt

| Recherchenort | Abschlußdatum der Recherche | Prüfer |
|---|---|---|
| DEN HAAG | 20.April 1998 | Van Bommel, L |

KATEGORIE DER GENANNTEN DOKUMENTE

X : von besonderer Bedeutung allein betrachtet  
Y : von besonderer Bedeutung in Verbindung mit einer anderen Veröffentlichung derselben Kategorie  
A : technologischer Hintergrund  
O : nichtschriftliche Offenbarung  
P : Zwischenliteratur

T : der Erfindung zugrunde liegende Theorien oder Grundsätze  
E : älteres Patentdokument, das jedoch erst am oder nach dem Anmeldedatum veröffentlicht worden ist  
D : in der Anmeldung angeführtes Dokument  
L : aus anderen Gründen angeführtes Dokument  
............................................................  
& : Mitglied der gleichen Patentfamilie, übereinstimmendes Dokument

EPO FORM 1503 03 82 (P04C03)

14